# EUROPEAN PATENT APPLICATION

(11) **EP 3 502 723 A1**
(43) Date of publication of application: **26.06.2019**
(21) Application number: 18212239.0
(22) Date of filing: 13.12.2018
(51) Int. Cl.: G01R 31/42, G01R 19/165, G01R 31/02, G01R 31/40

(54) **PROGRAM, SYSTEM AND METHOD FOR DETERMINATION OF PHASE LOSS ALTERNATING POWER SUPPLY**

(30) Priority: 18.12.2017 JP 2017241912
(71) Applicant: MITSUBISHI HEAVY INDUSTRIES THERMAL SYSTEMS, LTD., 108-8215 Tokyo (JP)
(72) Inventor: OONO, Kenzo, Tokyo, 108-8215 (JP); SUMIYA, Atsuyuki, Tokyo, 108-8215 (JP)
(74) Representative: Henkel, Breuer & Partner

(57) **Abstract**

The determination system includes a converter having a current sensor configured to measure a current flowing through a load and to output a signal corresponding to the measured current; and a determination circuit configured to determine presence or absence of a phase loss in an alternating current power supply configured to supply an alternating current voltage to the converter on the basis of the signal output, a first threshold value, and a second threshold value, wherein the signal is output from the current sensor, the first threshold value defines an upper limit of the signal that the current sensor outputs when there is no phase loss in the alternating current power supply, and the second threshold value defines a lower limit of the signal that the current sensor outputs when there is no phase loss in the alternating current power supply.

## Description

### BACKGROUND OF THE INVENTION

### Field of the Invention

The present invention relates to a determination system, a determination method for the determination system, and a program.

### Description of Related Art

A power supply circuit for converting alternating current (AC) power into direct current (DC) power is known. This power supply circuit is generally called a converter. Sometimes, an AC voltage to be input to this converter has a plurality of phases, for example, like a three-phase AC power supply, and a problem of loss (disconnection or the like) of one of the plurality of phases may occur.

Patent Document 1 describes a technology in which an AC power waveform is read, FFT calculation is performed on the AC power waveform, and a phase loss is determined from frequency components included in the AC power waveform obtained as a result of the calculation.

### [Patent Documents]

[Patent Document 1] Japanese Patent No. 3460461

### SUMMARY OF THE INVENTION

Incidentally, if AC power (particularly, an AC current) drawn from the AC power supply to the converter is distorted, this may have an adverse effect such as distortion or the like on the AC power supply side, that is, in the power system. Therefore, a converter having an active filter for correcting AC power drawn from the AC power supply to the converter is provided. A converter in which a rectifier circuit is composed of switching elements is also provided. Such converters sometimes perform control according to a current supplied to a load and some of the converters include a current sensor that measures a return current from the load to the AC power supply.

Thus, a technology which can effectively utilize the current sensor provided in the converter is required.

It is an object of the present invention to provide a determination system, a determination method for the determination system, and a program which can solve the above problems.

According to a first aspect of the present invention, a determination system includes a converter having a current sensor configured to measure a current flowing through a load and to output a signal corresponding to the measured current; and a determination circuit configured to determine presence or absence of a phase loss in an alternating current power supply configured to supply an alternating current voltage to the converter on the basis of the signal output, a first threshold value, and a second threshold value, wherein the signal is output from the current sensor, the first threshold value defines an upper limit of the signal that the current sensor outputs when there is no phase loss in the alternating current power supply, and the second threshold value defines a lower limit of the signal that the current sensor outputs when there is no phase loss in the alternating current power supply.

According to a second aspect of the present invention, in the determination system according to the first aspect, the current sensor includes a resistor and a differential amplifier, the resistor is configured to measure a current flowing through the load, the differential amplifier is configured to output a voltage corresponding to the current measured by the resistor, and the determination circuit is configured to determine presence or absence of the phase loss in the alternating current power supply on the basis of the voltage output and a predetermined range of the voltage, the alternating current power supply supplying the alternating current voltage to the converter, the voltage is output from the differential amplifier, and a predetermined range of the voltage is output from the differential amplifier when there is no phase loss in the alternating current power supply.

According to a third aspect of the present invention, a determination method for a determination system including a converter having a current sensor configured to measure a current flowing through a load and to output a signal corresponding to the measured current, the determination method includes determining presence or absence of a phase loss in an alternating current power supply configured to supply an alternating current voltage to the converter on the basis of the signal output, a first threshold value, and a second threshold value, wherein the signal is output from the current sensor, the first threshold value defines an upper limit of the signal that the current sensor outputs when there is no phase loss in the alternating current power supply, and the second threshold value defines a lower limit of the signal that the current sensor outputs when there is no phase loss in the alternating current power supply.

According to a fourth aspect of the present invention, a program causes a computer for a determination system, which includes a converter having a current sensor configured to measure a current flowing through a load and to output a signal corresponding to the measured current, to execute, determining presence or absence of a phase loss in an alternating current power supply configured to supply an alternating current voltage to the converter on the basis of the signal output, a first threshold value, and a second threshold value, wherein the signal is output from the current sensor, the first threshold value defines an upper limit of the signal that the current sensor outputs when there is no phase loss in the alternating current power supply, and the second threshold value defines a lower limit of the signal that the current sensor outputs when there is no phase loss in the alternating current power supply.

With the determination system according to embodiments of the present invention, it is possible to effectively utilize the current sensor provided in the converter.

### BRIEF DESCRIPTION OF THE DRAWINGS

FIG. 1 is a diagram showing a configuration of an air conditioning system according to an embodiment of the present invention.
FIG. 2 is a diagram for explaining determination of a phase loss in an air conditioning system according to an embodiment of the present invention.

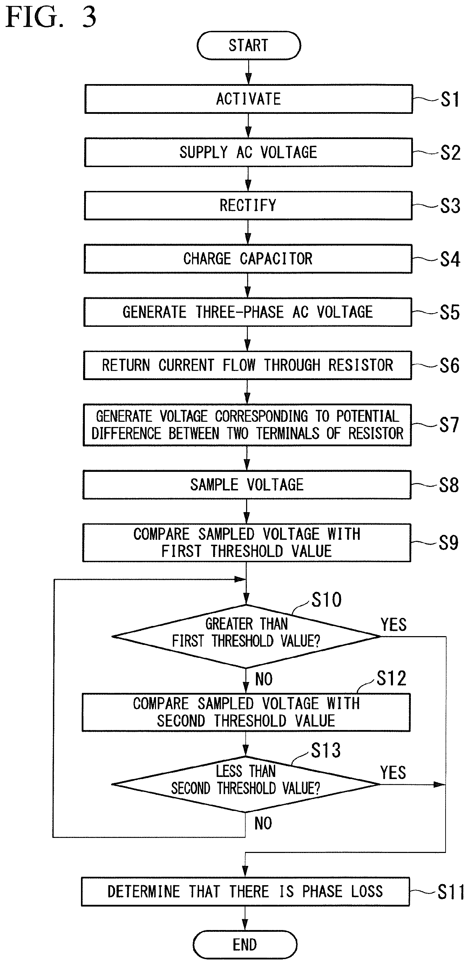

FIG. 3 is a diagram showing a process flow of an air conditioning system according to an embodiment of the present invention.

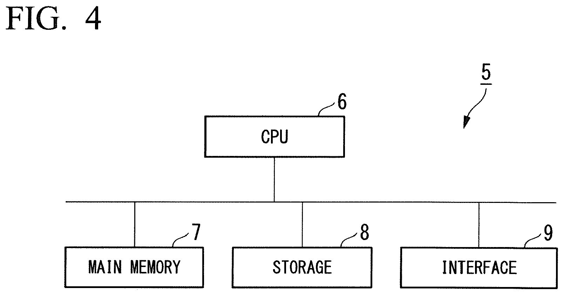

FIG. 4 is a schematic block diagram showing a configuration of a computer according to at least one embodiment.

### DETAILED DESCRIPTION OF THE INVENTION

### <Embodiments>

Hereinafter, a configuration of an air conditioning system according to an embodiment of the present invention will be described.

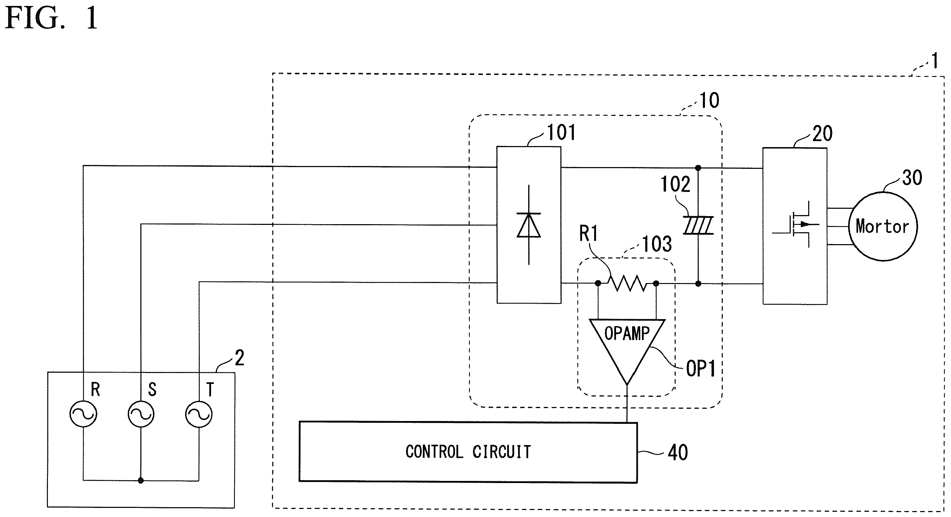

The air conditioning system 1 according to the embodiment of the present invention is a system for determining a phase loss of an input AC power supply using a current sensor already provided in a converter. As shown in FIG. 1, the air conditioning system 1 (an example of the determination system) includes a converter 10, an inverter 20, a motor 30, and a control circuit 40 (an example of the determination circuit).

As shown in FIG. 1, the converter 10 includes a rectifier circuit 101, a capacitor 102, and a current sensor 103. The converter 10 converts an AC voltage output from a three-phase AC power supply 2 into a DC voltage. Further, the converter 10 measures a current for determining a phase loss in the three-phase AC power supply 2.

The rectifier circuit 101 receives the AC voltage output from the AC power supply 3. The rectifier circuit 101 rectifies the received AC voltage.

The rectifier circuit 101 charges the capacitor 102 with the rectified voltage.

The capacitor 102 is a smoothing capacitor and stabilizes the output voltage of the converter 10 at a constant voltage. The constant voltage at which the capacitor 102 is stabilized is supplied to the inverter 20.

The current sensor 103 measures a current flowing through the motor 30, which is a load of the converter 10, using a return current to the three-phase AC power supply 2 and outputs the measurement result to the control circuit 40. For example, as shown in FIG. 1, the current sensor 103 includes a resistor R1, which is provided in series in a path through which the return current flows, from the motor 30 to the three-phase AC power supply 2, and a differential amplifier OP1 (denoted as "OPAMP" in FIG. 1) which outputs a voltage corresponding to the potential difference between two terminals of the resistor R1. In this case, the current sensor 103 measures the return current as the potential difference between the two terminals of the resistor R1, converts the measured potential difference into a voltage corresponding to the potential difference through the differential amplifier OP1, and outputs the voltage to the control circuit 40.

The inverter 20 generates a three-phase AC voltage for driving the motor 30 from the DC voltage generated by the converter 10.

The motor 30 rotates in accordance with the three-phase AC voltage generated by the inverter 20. The motor 30 is, for example, a compressor motor.

The control circuit 40 determines the phase loss of the three-phase AC power supply 2 on the basis of the output voltage of the current sensor 103 received from the converter 10. Specifically, the control circuit 40 compares the output voltage of the current sensor 103 with first and second threshold values which are threshold values for determining whether or not the current value has deviated from a current range in the case of absence of the phase loss, wherein the first threshold value is a threshold value for determining whether or not the current value has deviated from an upper limit of the current value in the case of absence of the phase loss and the second threshold value is a threshold value for determining whether or not the current value has deviated from a lower limit of the current value in the case of absence of the phase loss. Then, upon determining that the output voltage of the current sensor 103 is between the first threshold value and the second threshold value, the control circuit 40 determines that there is no phase loss. Upon determining that the output voltage of the current sensor 103 is greater than the first threshold value or is less than the second threshold value, the control circuit 40 determines that there is a phase loss.

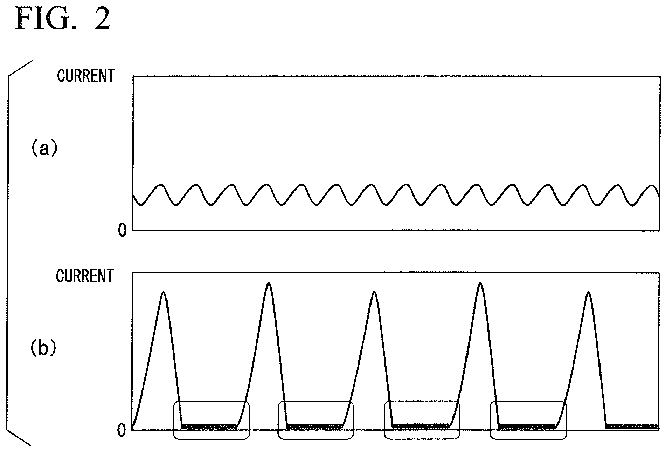

The control circuit 40 performs the determination in the following manner. When there is no phase loss, the current fluctuates within a limited range of current values as shown in FIG. 2(a). On the other hand, when there is a loss of one of the three phases in the three-phase AC power supply 2, no current flows through a wire corresponding to the missing phase. Therefore, a period in which the current flowing through the resistor R1 is substantially 0 necessarily occurs periodically as shown in FIG. 2(b). The second threshold value is a threshold value for determining this lower limit. Further, when there is a phase loss, an electric charge is discharged from the capacitor 102 to the inverter 20 during the period in which the current is substantially 0. On the other hand, when a current flows between the two phases which are not missing, a current for charging the capacitor 102 flows such that a period in which the current value is greater than the upper limit of the current value in the case of absence of the phase loss occurs periodically as shown in FIG. 2(b). The first threshold value is a threshold value for determining this upper limit. Note that the period in which the current flowing through the resistor R1 is substantially 0 is not a momentary short period but a period corresponding to the frequency of the three-phase AC power supply 2. Since a general control circuit operates sufficiently faster than the period in which the current flowing through the resistor R1 is substantially 0, the control circuit 40 can perform this determination during the period in which the current flowing through the resistor R1 is substantially 0.

Next, processing of the air conditioning system 1 according to an embodiment of the present invention will be described with reference to FIG. 2.

When the air conditioning system 1 is activated (step S1) and an AC voltage is supplied from the three-phase AC power supply 2 to the air conditioning system 1 (step S2), the rectifier circuit 101 rectifies the AC voltage received from the three-phase AC power supply 2 (step S3). The rectifier circuit 101 charges the capacitor 102 with the rectified voltage (step S4). The capacitor 102 stabilizes the output voltage of the converter 10 at a constant voltage and supplies the voltage to the inverter 20.

The inverter 20 generates a three-phase AC voltage for driving the motor 30 from the DC voltage generated by the converter 10 (step S5).

The motor 30 rotates in accordance with the three-phase AC voltage generated by the inverter 20. At this time, the current flowing through the motor 30 according to the three-phase AC voltage generated by the inverter 20 flows through the resistor R1 as a return current (step S6).

The differential amplifier OP1 receives the potential difference between the two terminals of the resistor R1. The differential amplifier OP1 generates a voltage corresponding to the received potential difference (step S7) and constantly outputs the generated voltage to the control circuit 40.

The control circuit 40 samples the voltage received from the differential amplifier OP1 at intervals of a predetermined time which is sufficiently shorter than the period in which the current flowing through the resistor R1 is substantially 0 (step S8). The control circuit 40 compares the voltage value of the sampled voltage with the first threshold value (step S9). Then, the control circuit 40 determines whether or not the voltage value of the sampled voltage is greater than the first threshold value (step S10).

Upon determining that the voltage value of the sampled voltage is greater than the first threshold value (YES in step S10), the control circuit 40 determines that there is a phase loss in the three-phase AC power supply 2 (step S11).

On the other hand, upon determining that the voltage value of the sampled voltage is equal to or less than the first threshold value (NO in step S10), the control circuit 40 compares the voltage value of the sampled voltage with the second threshold value (step S12). Then, the control circuit 40 determines whether or not the voltage value of the sampled voltage is less than the second threshold value (step S13).

Upon determining that the voltage value of the sampled voltage is less than the second threshold value (YES in step S13), the control circuit 40 determines that there is a phase loss in the three-phase AC power supply 2 (step S11).

Upon determining that the voltage value of the sampled voltage is equal to or greater than the second threshold value (NO in step S13), the control circuit 40 returns to the process of step S10 and repeats the processes of the above steps S10 to S13 after a predetermined time sufficiently shorter than the period in which the current flowing through the resistor R1 is substantially 0 has elapsed.

The air conditioning system 1 according to an embodiment of the present invention has been described above. The air conditioning system 1 (an example of the determination system) includes the converter 10 having the current sensor 103, and the control circuit 40. The current sensor 103 measures a current flowing through the motor 30 which is a load and outputs a signal corresponding to the current value of the current to the control circuit 40. The control circuit 40 determines the phase loss of the three-phase AC power supply 2 on the basis of whether or not the signal received from the current sensor 103 is within a predetermined range of the signal that the current sensor 103 outputs when there is no phase loss in the three-phase AC power supply 2.

Since the control circuit 40 determines the presence or absence of the phase loss with respect to the signal received from the current sensor 103 at intervals of a predetermined time, it is possible to achieve determination of the phase loss of the three-phase AC power supply 2 in addition to the original use of the current sensor 103 (for example, control of switching elements of the rectifier circuit, control of the active filter, and the like).

As a result, it is possible to effectively utilize the current sensor provided in the converter.

It is to be noted that, in another embodiment of the present invention, the control circuit 40 may determine that there is a phase loss when a current of substantially 0 amperes flowing through the resistor R1 is measured more than once.

In the processing according to the embodiment of the present invention, the order of processes may be changed within a scope in which appropriate processing is performed.

Storage units may be provided anywhere within a scope in which appropriate information transmission/reception is performed. Each of the storage units may also store data such that the data is stored in a distributed manner over a plurality of parts of the storage unit within a scope in which appropriate information transmission/reception is performed.

Although embodiments of the present invention have been described, each of the control circuit 40 described above and other control devices may have a computer system therein. The procedures of the above processes are stored in a computer-readable recording medium in the form of a program, and the above processes are performed by a computer reading and executing the program. A specific example of the computer is shown below.
FIG. 5 is a schematic block diagram showing a configuration of the computer according to at least one embodiment.

As shown in FIG. 5, the computer 5 includes a CPU 6, a main memory 7, a storage 8, and an interface 9.

For example, each of the control circuit 40 described above and other control devices is mounted in the computer 5. The operation of each processing unit described above is stored in the storage 8 in the form of a program. The CPU 6 reads the program from the storage 8, loads the program in the main memory 7, and executes the above processes in accordance with the program. The CPU 6 reserves storage areas corresponding to the storage units described above in the main memory 7 in accordance with the program.

Examples of the storage 8 include a hard disk drive (HDD), a solid state drive (SSD), a magnetic disk, a magneto-optical disc, a compact disc read only memory (CD-ROM), a digital versatile disc read only memory (DVD-ROM), a semiconductor memory, and the like. The storage 8 may be an internal medium that is directly connected to a bus of the computer 5 or may be an external medium that is connected to the computer 5 via the interface 9 or a communication line. Further, when the program is delivered to the computer 5 through a communication line, the computer 5 which has received the program may load the program in the main memory 7 and execute the above processes. In at least one embodiment, the storage 8 is a non-transitory physical storage medium.

Furthermore, the program may be one for realizing some of the above-described functions. The program may also be a so-called differential file (differential program) which can realize the above-described functions in combination with a program already recorded in the computer system.

Although embodiments of the present invention have been described, these embodiments are examples and do not limit the scope of the invention. Various additions, omissions, substitutions, and changes may be made to these embodiments without departing from the gist of the invention.

### EXPLANATION OF REFERENCES

- 1: Air conditioning system
- 2: Three-phase AC power supply
- 10: Converter
- 20: Inverter
- 30: Motor
- 40: Control circuit
- 101: Rectifier circuit
- 102: Capacitor
- 103: Current sensor
- OP1: Differential amplifier
- R1: Resistor

## Claims

1. A determination system (1) comprising:
a converter (10) having a current sensor (103) configured to measure a current flowing through a load and to output a signal corresponding to the measured current; and
a determination circuit (40) configured to determine presence or absence of a phase loss in an alternating current power supply configured to supply an alternating current voltage to the converter on the basis of the signal output, a first threshold value, and a second threshold value,
wherein the signal is output from the current sensor,
the first threshold value defines an upper limit of the signal that the current sensor outputs when there is no phase loss in the alternating current power supply, and
the second threshold value defines a lower limit of the signal that the current sensor outputs when there is no phase loss in the alternating current power supply.

2. The determination system according to claim 1,
wherein the current sensor includes a resistor (R1) and a differential amplifier (OP1),
the resistor is configured to measure a current flowing through the load,
the differential amplifier is configured to output a voltage corresponding to the current measured by the resistor, and
the determination circuit is configured to determine presence or absence of the phase loss in the alternating current power supply on the basis of the voltage output and a predetermined range of the voltage, the alternating current power supply supplying the alternating current voltage to the converter, the voltage is output from the differential amplifier, and a predetermined range of the voltage is output from the differential amplifier when there is no phase loss in the alternating current power supply.

3. A determination method for a determination system including a converter having a current sensor configured to measure a current flowing through a load and to output a signal corresponding to the measured current, the determination method comprising:
determining presence or absence of a phase loss in an alternating current power supply configured to supply an alternating current voltage to the converter on the basis of the signal output, a first threshold value, and a second threshold value,
wherein the signal is output from the current sensor,
the first threshold value defines an upper limit of the signal that the current sensor outputs when there is no phase loss in the alternating current power supply, and
the second threshold value defines a lower limit of the signal that the current sensor outputs when there is no phase loss in the alternating current power supply.

4. A program causing a computer for a determination system, which includes a converter having a current sensor configured to measure a current flowing through a load and to output a signal corresponding to the measured current, to execute:
determining presence or absence of a phase loss in an alternating current power supply configured to supply an alternating current voltage to the converter on the basis of the signal output, a first threshold value, and a second threshold value,
wherein the signal is output from the current sensor,
the first threshold value defines an upper limit of the signal that the current sensor outputs when there is no phase loss in the alternating current power supply, and
the second threshold value defines a lower limit of the signal that the current sensor outputs when there is no phase loss in the alternating current power supply.
